(19) Europäisches Patentamt / European Patent Office / Office européen des brevets

(11) **EP 1 417 503 B1**

(12) **EUROPÄISCHE PATENTSCHRIFT**

(45) Veröffentlichungstag und Bekanntmachung des Hinweises auf die Patenterteilung:
**17.02.2010 Patentblatt 2010/07**

(21) Anmeldenummer: **02742798.8**

(22) Anmeldetag: **06.06.2002**

(51) Int Cl.:
**G01R 31/36** (2006.01)

(86) Internationale Anmeldenummer:
**PCT/DE2002/002053**

(87) Internationale Veröffentlichungsnummer:
**WO 2003/005052 (16.01.2003 Gazette 2003/03)**

(54) **VERFAHREN ZUR ERMITTLUNG DES LADEZUSTANDS UND/ODER DER LEISTUNGSFÄHIGKEIT EINES LADUNGSSPEICHERS**

METHODS FOR DETERMINING THE CHARGE STATE AND/OR THE POWER CAPACITY OF A CHARGE STORE

PROCEDES POUR DETERMINER L'ETAT DE CHARGE ET/OU LA PUISSANCE D'UN ACCUMULATEUR DE CHARGE

(84) Benannte Vertragsstaaten:
**DE ES FR GB IT SE**

(30) Priorität: **29.06.2001 DE 10131267**
**31.01.2002 DE 10203810**

(43) Veröffentlichungstag der Anmeldung:
**12.05.2004 Patentblatt 2004/20**

(73) Patentinhaber: **ROBERT BOSCH GMBH**
**70442 Stuttgart (DE)**

(72) Erfinder: **SCHOCH, Eberhard**
**70469 Stuttgart (DE)**

(56) Entgegenhaltungen:
| | |
|---|---|
| **EP-A2- 0 994 362** | **DE-A1- 19 847 648** |
| **DE-A1- 19 959 019** | **DE-C1- 19 960 761** |
| **US-A- 5 825 218** | **US-A- 5 883 497** |

EP 1 417 503 B1

**Beschreibung**

Stand der Technik

Aus der Literatur sind verschiedene Verfahren zur Bestimmung des Ladezustands und der Leistungsfähigkeit elektrischer Energiespeicher insbesondere der im Kfz-Bereich üblichen Bleiakkumulatoren bekannt. Bei einem großen Teil der Verfahren wird der Ladezustand aus der bei Bleiakkumulatoren im unbelasteten Fall gemessenen Ruhespannung ermittelt, da diese in einem weiten Ladezustandsbereich proportional zur Säuredichte ist (Ruhespannungsverfahren). Zur Abschätzung der Leistungsfähigkeit bzw. Belastbarkeit des Energiespeichers bezüglich eines vorgegebenen Verbraucherstroms bzw. Verbraucherleistung wird neben der Ruhespannung bzw. dem Ladezustand auch der Innenwiderstand benötigt, der bei Starterbatterien idealerweise während der Hochstrombelastung beim Motorstart aus dem Differenzenquotienten der gemessenen Spannungs- u. Stromwerte berechnet wird. Ein Verfahren, bei dem der Ladezustand einer Batterie so ermittelt wird, ist beispielsweise aus der DE-P 198 47 648 bekannt.

Beim Einsatz sicherheitskritischer elektrischer Verbraucher im Kfz wie z.B. steer-by-wire bzw. brake-by-wire Systemen aber auch für Batterie- u. Verbrauchermanagementsysteme wird die kontinuierliche Information über den Ladezustand und die Leistungsfähigkeit der Energiespeicher benötigt, so dass die Ruhespannung bzw. der Ladezustand auch in Lade- und/oder in Entladephasen und der Innenwiderstand auch bei fehlender Hochstrombelastung ermittelt werden muss. Der Ladezustand wird dazu meist durch Ladebilanzierung über das Stromintegral und der Innenwiderstand über fest vorgegebene Kennlinien in Abhängigkeit von Ladezustand u. Batterietemperatur extrapoliert. Dieses Verfahren führt jedoch bei längerem Betrieb des Energiespeichers ohne Ruhephasen bzw. Hochstrombelastung sowie aufgrund der in den Kennlinien nicht berücksichtigten Alterungseinflüsse zu Fehlern in der Abschätzung von Ladezustand und Leistungsfähigkeit.

Zur Vermeidung dieser Fehler werden in der Literatur modellbasierte Schätzverfahren vorgeschlagen, die die Zustandsgrößen u. Parameter eines mathematischen Modells des Energiespeichers ständig durch kontinuierliche Messung von Spannung, Strom u. Temperatur an die echten Zustandsgrößen u. Parameter anpassen. Solche modellbasierten Schätzverfahren sind beispielsweise aus der DE-P 199 59 019.2 bekannt. Ladezustand und Leistungsfähigkeit des Energiespeichers werden bei den bekannten Verfahren aus den so ermittelten Zustandsgrößen u. Parametern berechnet. Nachteil dieser Verfahren ist, dass zur Abdeckung des gesamten Betriebsbereichs des Energiespeichers bezüglich Entlade-/Ladestrombereich, Ladezustand, Temperatur sowie Alterungseinflüsse ein komplexes in der Regel nichtlineares Modell des Energiespeichers mit vielen zu schätzenden Zustandsgrößen u. Parametern benötigt wird, das nur mit großem Aufwand ausgewertet werden kann.

Alternative einfachere Modelle, die nur einzelne Arbeitspunkte der Batterie, beispielsweise nur den Entladefall abdecken bringen hier Vorteile, lassen jedoch nur in diesen Arbeitspunkten eine genaue Bestimmung von Ladezustand u. Leistungsfähigkeit zu Solche einfachen Modelle werden beispielsweise in der DE-P 100 56 969 beschrieben.

Aus der DE 199 60 761 C1 ist bereits ein Verfahren zur Überwachung der Restladung und der Leistungsfähigkeit einer Batterie bekannt. Hierzu werden an einer belasteten Batterie mindestens zwei Strom-Spannungsmessungen durchgeführt.

Aufgabe der Erfindung

Die Aufgabe der Erfindung ist, eine möglichst genaue Bestimmung des Ladezustandes bzw. der Leistungsfähigkeit eines Ladungsspeichers über einen großen Arbeitsbereich ohne zu großen Aufwand zu ermöglichen. Gelöst wird diese Aufgabe durch ein Verfahren mit den Merkmalen des Anspruchs 1. Dieses erfindungsgemäße Verfahren ermöglicht durch gewichtete Korrektur der aus mindestens zwei in unterschiedlichen Betriebspunkten des Energiespeichers aktiven Verfahren mittels kontinuierlicher Messung von Spannung, Strom u. Temperatur geschätzten Zustandsgrößen u. Parametern eine gegenüber den Einzelverfahren genauere Abschätzung von aktuellem u. zukünftigem Ladezustand u. Leistungsfähigkeit über einen großen Arbeitsbereich des Energiespeichers insbesondere einer Kfz-Bleibatterie.

Vorteile der Erfindung

Das erfindungsgemäße Verfahren mit den Merkmalen des Anspruchs 1 verbindet den Vorteil der Ruhespannungsverfahren; nämlich der genauen Bestimmung der Ruhespannung bzw. des Ladezustands in Phasen mit unbelasteter Batterie sowie des Innenwiderstands bei Hochstrombelastung (z.B. Motorstart) mit dem Vorteil einfacher modellbasierter Schätzverfahren, Ruhespannung u. Innenwiderstand sowie optionale weitere Zustandsgrößen u. Parameter auch im Betrieb ohne Ruhephasen u. Hochstrombelastungen schätzen zu können u. ermöglicht so eine gegenüber den Einzelverfahren genauere Bestimmung von Ladezustand u. Leistungsfähigkeit über einen großen Arbeitsbereich der Batterie ohne aufwendige Batteriemodelle.

Weitere Vorteile der Erfindung werden durch die in den Unteransprüchen angegebenen Merkmale erzielt. Die zur Berechnung des Ladezustands u. der Leistungsfähigkeit mindestens benötigten Größen Ruhespannung u. Innenwiderstand sowie optionale weitere Zustandsgrößen u. Parameter werden dabei in vorteilhafter Weise durch gewichtete Korrektur aus den Werten der Einzelverfahren berechnet, wobei deren Gewichtung entsprechend ihrer Zuverlässigkeit im aktuellen Arbeitspunkt der Batterie gewählt wird.

Durch Extrapolation der aktuell geschätzten Zustandsgrößen u. Parameter bezüglich Ladezustand u. Temperatur auf einen späteren Zeitpunkt, sind auch Prognosen der Leistungsfähigkeit in die Zukunft möglich, so dass mit dem beschriebenen Verfahren z.B. auch die Startfähigkeit der Batterie in einem über mehrere Tage abgestellten Fahrzeug abgeschätzt werden kann.

Beschreibung

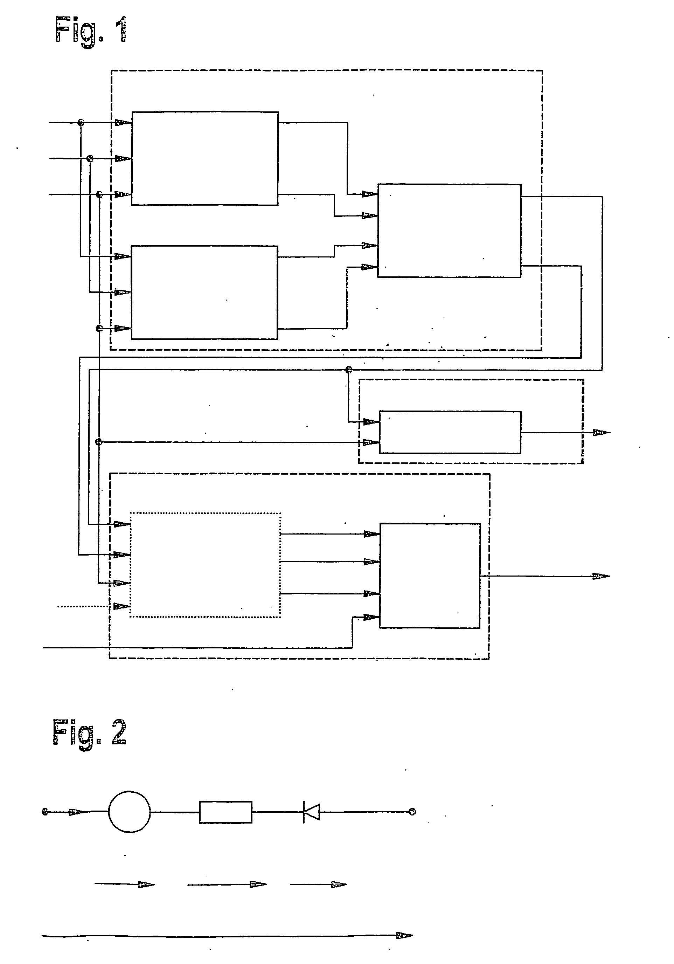

Figur 1 zeigt die prinzipielle Struktur der Batteriezustandserkennung mit zwei in verschiedenen Betriebspunkten der Batterie aktiven Zustands- und Parameterschätzverfahren. Die Anzahl der verwendeten Verfahren ist nicht notwendigerweise auf zwei beschränkt, wobei jedoch mindestens ein Verfahren modellbasiert arbeitet, d.h. die Zustandsgrößen u. Parameter eines Batteriemodells z.B. über einen rekursiven least-square-Schätzer, beispielsweise ein Extended-Kalman-Filter an die realen Werte adaptiert.

Die Zustands- u. Parameterschätzung ermittelt aus der kontinuierlichen Messung von Batteriespannung $U_{Batt}$, Batteriestrom $I_{Batt}$ u. Batterietemperatur $T_{Batt}$ die zur Bestimmung des Ladezustands u. der Leistungsfähigkeit der Batterie benötigten Zustandsgrößen $\underline{z}$ (z.B. Ruhespannung $U_{00}$) und Parameter $\underline{p}$ (z.B. Innenwiderstand $R_i$). Die Ladezustandsberechnung bestimmt aus dem Vektor $\underline{z}$ der Zustandsgrößen und der aktuellen Batterietemperatur $T_{Batt}$ den Ladezustand soc (state of charge), während die aktuelle Leistungsfähigkeit der Batterie über die Spannungsantwort $U_{Batt,präd}$ (t) eines mit dem Zustands vektor $\underline{z}$ u. dem Parametervektor $\underline{p}$ initialisierten Batteriemodells auf ein vorgegebenes Laststromprofil $I_{Last}$ (t) beurteilt wird.

Interessiert die Leistungsfähigkeit der Batterie zu einem zukünftigen Zeitpunkt, z.B. wenn nach der Startfähigkeit der Batterie nach mehreren Tagen Standzeit des Fahrzeugs gefragt wird, werden die aktuellen Zustandsgrößen $\underline{z}$ u. Parameter $\underline{p}$ sowie die aktuelle Batterietemperatur $T_{Batt}$ auf die zum zukünftigen Zeitpunkt zu erwartenden Werte $\underline{z}'$, $\underline{p}'$ u. $T_{Batt}'$ extrapoliert. Insbesondere muss dazu der Ruhestromverlauf $I_{Ruhe}$ (t) im abgestellten Fahrzeug bekannt sein, um die Ladezustandsabnahme in Abhängigkeit von der Standzeit des Fahrzeugs vorausberechnen zu können.

Über ein Verfahren A, hier als Ruhespannungsverfahren bezeichnet, wird in Phasen mit unbelasteter Batterie die Ruhespannung $U_{00}$ und während einer Hochstrombelastung (z.B. Motorstart) der Innenwiderstand $R_i$ der Batterie ermittelt. Zusätzlich können weitere Größen wie z.B. die (Säure-)Kapazität $Q_0$ aus den Messgrößen Strom $I_{Batt}$, Spannung $U_{Batt}$ u. Temperatur $T_{Batt}$ bzw. den berechneten Größen $U_{00}$ und $R_i$ abgeleitet werden. Die vom Verfahren A bestimmten Zustandsgrößen werden im Zustandsvektor $\underline{z}_A$ die Parameter im Vektor $\underline{p}_A$ zusammengefasst. Das Verfahren B ist modellbasiert und schätzt ebenfalls mindestens die Ruhespannung $U_{00}$ und den Innenwiderstand $R_i$ jedoch auch in gegenüber Erfahren A anderen bzw. zusätzlichen Betriebspunkten der Batterie (z.B. Entladung). Die vom Verfahren B bestimmten Zustands-größen werden im Zustandsvektor $\underline{z}_B$ die Parameter im Vektor $\underline{p}_B$ zusammengefasst.

In jedem Rechenschritt k wird der Zustandsvektor $\underline{z}_{k+1}$ mittels der gewichteten Differenzen $\underline{z}_{A,k}-\underline{z}_k$, $\underline{z}_{B,k}-\underline{z}_k$. und der Parametervektor $\underline{p}_{k+1}$ mittels der gewichteten Differenzen $\underline{p}_{A,k}-\underline{p}_k$, $\underline{p}_{B,k}-\underline{p}_k$ beginnend mit den Startwerten $\underline{z}_{k=0}=\underline{z}_0$ u. $\underline{p}_{k=0}=\underline{p}_0$ berechnet:

$$\underline{z}_{k+1} = \underline{z}_k + \underline{G}_{z,A} * (\underline{z}_{A,k}-\underline{z}_k) + \underline{G}_{z,B} * (\underline{z}_{B,k}-\underline{z}_k)$$

$$\underline{p}_{k+1} = \underline{p}_k + \underline{G}_{p,A} * (\underline{p}_{A,k}-\underline{p}_k) + \underline{G}_{p,B} * (\underline{p}_{B,k}-\underline{p}_k)$$

Die Gewichtungsmatrizen $\underline{G}_{z,A}$, $\underline{G}_{z,B}$, $\underline{G}_{p,A}$ u. $\underline{G}_{p,B}$ sind quadratische Diagonalmatrizen, deren Hauptdiagonalelemente $g_{z,A,i=1..n}$, $g_{z,B,i=1..n}$, $g_{p,A,j=1..m}$, $g_{z,B,j=1..m}$ die Stärke der Korrektur der n Zustandsgrößen u. der m Parameter festlegen u. nachfolgende Bedingungen erfüllen müssen, damit die Folgen $\underline{z}_{k=0}$, $\underline{z}_{k=1}$, $\underline{z}_{k=2}$ $\cdots$ u. $\underline{p}_{k=0}$, $\underline{p}_{k=1}$, $\underline{p}_{k=2}$ ... konvergieren:

$$g_{z,A,i} + g_{z,B,i} \leq 1, \quad i=1...n$$

$$g_{p,A,j} + g_{p,B,j} \leq 1, \quad j=1...m$$

Die Gewichtungen werden so gewählt, dass Zustandsgrößen bzw. Parameter, die im aktuellen Betriebspunkt durch ein Verfahren genauer bestimmt werden als durch das andere entsprechend stärker zur Korrektur beitragen. Beispielsweise dürfen die Schätzgrößen des modellbasierten Verfahrens nur dann in die Korrektur einfließen, wenn der Schätzalgorithmus eingeschwungen ist, die Schätzgrößen eindeutig identifiziert werden können (Beobachtbarkeit) und sich die Batterie in Arbeitspunkten bewegt, die auch durch das zugrundegelegte Modell beschrieben werden (z.B. Entladung). In allen anderen Fällen müssen die entsprechenden Gewichte $g_{z,B,i}$ u. $g_{p,B,j}$ = 0 gesetzt werden.

Im folgenden wird ein Beispiel einer speziellen Ausführungsvariante der Batteriezustandserkennung zur Prädiktion der Leistungsfähigkeit von Bleibatterien im Kfz näher beschrieben:

Prädiktormodell

Zur Abschätzung der Leistungsfähigkeit einer Bleibatterie bei kurzzeitiger Belastung (Größenordnung 10sec) mit Strömen in der Größenordnung von $I_{Last} \leq -100A$ (Zählrichtung: I < 0A für Entladen), wie sie z.B. typischerweise beim Betrieb elektrischer Brems- u. Lenksysteme sowie beim Motorstart im Kfz auftritt. Es kann dabei folgendes einfache, in Figur 2 dargestellte Prädiktionsmodell benutzt werden:

mit den Ersatzschaltbildkomponenten:

| | |
|---|---|
| $I_{Last}$ = | vorgegebener Laststrom für den die Leistungsfähigkeit geprüft werden soll |
| $U_{00}$ = | Ruhespannung |
| $R_i$ = | ohmscher Innenwiderstand |
| Diode = | nichtlinearer Widerstand der Durchtrittspolarisation |
| $U_{ohm} = R_i * I_{Last}$ = | ohmscher Spannungsabfall bei vorgegebenem Stromprofil $I_{Last}$ |
| $U_D = f(I_{Last}, T_{Batt})$ = | Kennlinie des stationären Durchtrittspannungsabfalls bei vorgegebenem Stromprofil $I_{Last}$ u. der Batterietemperatur $T_{Batt}$ |

Aus Messungen ermittelter Ansatz:

$$U_D(I_{Last}, U_{D0}) = U_{D0} * \ln(I_{Last}/(-1A)), \quad I_{Last} < 0A$$

mit dem temperaturabhängigen Durchtrittsparameter:

$$U_{D}(T_{Batt}) = 4.97e\text{-}7 * (T_{Batt}/°C)^3 - 4.87e\text{-}5 * (T_{Batt}/°C)^2 + 1.82e\text{-}3 * (T_{Batt}/°C) ... -1.31e\text{-}1$$

$$U_{prädiziert} = U_{00} + R_i * I_{Last} + U_D(I_{Last}, U_{D0}) = \text{prädizierte}$$
$$\text{Spannungsantwort beim Batteriestrom } I_{Last}$$

Für die Anwendbarkeit des Prädiktionsmodells müssen folgende Voraussetzungen erfüllt sein:

die Ladungsentnahme durch das vorgegebene Lastprofil $I_{Last}$ (t) ist gegenüber der Batteriekapazität vernachlässigbar, d.h. die Ruhespannung $U_{00}$ kann als konstant angenommen werden,

die Durchtrittspannung schwingt während der Belastung mit $I_{Last}$ (t) auf ihren stationären durch die Kennlinie $U_D$ =

f ($I_{Last}$, $T_{Batt}$) vorgegebenen Endwert ein, d.h. die Belastung liegt ausreichend lange an bzw. ist ausreichend hoch (Zeitkonstante von $U_D \sim 1/I_{Last}$),

die im Modell nicht berücksichtigte Konzentrationsüberspannung, die durch Säuredichteunterschiede in der Batterie verursacht wird, ist vernachlässigbar,

die eventuell in zusätzlichen Kapazitäten (z.B. Doppelschichtkapazität zwischen Elektroden u. Elektrolyt) außerhalb der eigentlichen Batteriekapazität gespeicherten Ladungen werden nicht berücksichtigt (worst-case-Betrachtung).

Diese Voraussetzungen sind für den angegebenen Belastungsfall im Ladezustandsbereich von soc > ca. 30% und für Batterietemperaturen von $T_{Batt}$ > ca. 0°C sowie soc > ca. 50% und $T_{Batt}$ < ca. 0°C erfüllt.

Die Ermittlung der Zustandsgrößen u. Parameter des Prädiktormodells erfolgt ausgehend von folgenden Über-legungen:

Die Zustandsgröße $U_{00}$ sowie die Parameter $R_i$ u. $U_{D0}$ des Prädiktionsmodells werden durch zwei unterschiedliche Verfahren bestimmt:

Verfahren A ermittelt $U_{00,A}$ aus Leerlaufspannungsmessungen bei unbelasteter Batterie und $R_{i,A}$ durch Auswertung des Differenzenquotienten der beim Motorstart gemessenen Spannungs- u. Stromwerte, während der Durchtrittsparameter $U_{D0,A}$ vom Verfahren A nicht geschätzt, sondern über die oben angegebene Kennlinie berechnet wird.

Zusätzlich ermittelt Verfahren A aus zwei Ruhespannungsbestimmungen $U_{00,A,1}$ u. $U_{00,A,2}$ sowie dem Stro-mintegral (Ladebilanz) q = $\int I_{Batt}$ (t) dt dazwischen die Batterie(säure-)kapazität:

$$Q_{0,A} = q*(U_{00,max}(25°C) - U_{00,min}(25°C)) / (U_{00,A,2}(25°C) - U_{00,A,1}(25°C))$$

mit $U_{00,max}$ =Ruhespannung der vollgeladenen u. $U_{00,min}$ = Ruhespannung der leeren Batterie bei $T_{Batt}$=25°C.

Mit Hilfe von $Q_{0,A}$, der aktuellen Ladebilanz $q_k$ u. der aktuellen Batterietemperatur $T_{Batt,k}$ führt das Verfahren A die in der Ruhephase bestimmte Ruhespannung $U_{00,0}$ im Betrieb in jedem Zeitschritt k nach:

$$U_{00,A,k}(25°C) = U_{00,A,0}(25°C) + q_k/Q_{0,A}*(U_{00,max}(25°C) - U_{00,min}(25°C)$$

$$U_{00,A,k} = U_{00,A,k}(25°C) + Tk_{U00}*(T_{Batt,k}-25°C), \quad Tk_{U00}=1.38e-6V/°C$$

In ähnlicher Weise wird der beim Start ermittelte Innenwiderstand $R_{i,A,0}$ im Betrieb über ein Kennfeld in Abhängigkeit von der aktuellen Ruhespannung $U_{00,A,k}$ u. der aktuell gemessenen Batterietemperatur $T_{Batt,k}$ nachgeführt:

$$R_{i,k} = f(R_{i,A,0}, U_{00,A,k}, T_{Batt,k})$$

Verfahren B schätzt durch Abgleich eines geeigneten Batteriemodells im Entladebereich ($I_{Batt}$ < 0A) die Ruhespannung $U_{00,B}$, den Innenwiderstand $R_{i,B}$ sowie den Durchtrittsparameter $U_{D0,B}$ u. die Batteriekapazität $Q_{0,B}$. Durch gewichtete Korrektur werden aus den von Verfahren A u. B ermittelten Zustandsgrößen u. Parametern die zur Bestimmung von Ladezustand u. Leistungsfähigkeit benötigten Größen berechnet, wobei eine konstante Samplerate von 0.01sec für die einzelnen Zeitschritte angenommen wurde.

$$U_{00,k+1} = U_{00,k} + g_{U00,A}*(U_{00,A,k}-U_{00,k}) + g_{U00,B}*(U_{00,B,k}-U_{00,k})$$

mit

$$U_{00,0} = U_{00,A,0}, \quad g_{U00,A}=1-|q_k|/Q_0, \quad g_{U00,B}=|q_k|/Q_0$$

D.h. der aus einer Ruhephase mit Verfahren A bestimmte Startwert $U_{00,0} = U_{00,A,0}$ wird mit zunehmendem Betrag der Ladebilanz $|q_k|$ immer stärker durch den mit Verfahren B im Fzg-Betrieb ermittelten Wert $U_{00,B,k}$ korrigiert.

$$R_{i,k+1} = R_{i,k} + g_{Ri,A}*(R_{i,A,k}-R_{i,k}) + g_{Ri,B}*(R_{i,B,k}-R_{i,k})$$

mit

$$R_{i,0} = R_{i,A,0}, \quad g_{Ri,A}=0, \quad g_{Ri,B}=1.e-3$$

D.h. der beim Motorstart mit Verfahren A bestimmte Startwert $R_{i,0}=R_{i,A,0}$ wird mit der konstanten Gewichtung $g_{Ri,B}=1.e-3$ im Fzg-Betrieb auf den von Verfahren B ermittelten Wert $R_{i,B,k}$ korrigiert.

$$U_{D0,k+1} = U_{D0,k} + g_{UD0,A}*(U_{D0,A,k}-U_{D0,k}) + g_{UD0,B}*(U_{D0,B,k}-U_{D0,k})$$

mit

$$U_{D0,0} = U_{D0,A,0}, \quad g_{UD0,A}=0, \quad g_{UD0,B}=1.e-3$$

D.h. der mit Verfahren A über die Kennlinie $U_{D0}(T_{Batt})$ vorgegebene Durchtrittsparameter $U_{D0,A}$ wird mit der konstanten Gewichtung $g_{UD0,B}=1.e-3$ auf den im Fzg-Betrieb von Verfahren B geschätzten Wert $U_{D0,B,K}$ korrigiert.

Die Kapazität $Q_0$ wird für die Prädiktion der Leistungsfähigkeit zwar nicht benötigt, der von Verfahren A aus Ruhephasen ermittelte Wert $Q_{0,A,0}$ kann aber durch die im Fzg-Betrieb von Verfahren B geschätzten Werte $Q_{0,B,k}$ verbessert werden. Da die Genauigkeit von $Q_{0,B,k}$ mit wachsendem Betrag der Ladebilanz $|q_k|$ steigt, wurde die Gewichtung proportional zu diesem Wert gewählt.

$$Q_{0,k+1} = Q_{0,k} + g_{Q0,A}*(Q_{0,A,k}-Q_{0,k}) + g_{Q0,B}*(Q_{0,B,k}-Q_{0,k})$$

mit

$$Q_{0,0} = Q_{0,A,0}, \quad g_{Q0,A} = 0, \quad g_{Q0,B} = 5.e-4*|q_k|/Q_{0,k}$$

Berechnung des aktuellen Ladezustands:

Der relative Ladezustand soc wird aus der aktuell ermittelten Ruhespannung $U_{00}$ (Zustandsgröße) u. der aktuellen Batterietemperatur $T_{Batt}$ (Messgröße) berechnet: soc = $(U_{00}(25°C) -U_{00,min}(25°C)) / (U_{00,max}(25°C) -U_{00,min}(25°C))$ mit $U_{00}(25°C) = U_{00} - Tk_{U00}*(T_{Batt}-25°C)$, $Tk_{U00}=1.38e-6V/°C$ $U_{00,max}(25°C)$ = Maximalwert der Ruhespannung bei Raumtemperatur u. vollgeladener Batterie $U_{00,min}(25°C)$ = Minimalwert der Ruhespannung bei Raumtemperatur u. leerer Batterie (nach Entnahme der Ladung $Q_0$)

Berechnung der aktuellen Leistungsfähigkeit

Die aktuelle Leistungsfähigkeit wird über die mittels Prädiktormodell u. der aktuell geschätzten Zustandsgrößen u. Parameter ($U_{00}$, $R_i$, $U_{D0}$) berechnete Batteriespannung $U_{Batt,präd}$ bei vorgegebenem Laststrom $I_{Last}$ bestimmt:

$$U_{Batt,präd} = U_{00} + R_i * I_{Last} + U_D(I_{Last}, U_{D0})$$

Als absolutes Maß für die Leistungsfähigkeit des Energiespeichers (SOH = $\underline{S}$tate $\underline{o}$f $\underline{H}$ealth) kann der Abstand des Minimalwerts der prädizierten Batteriespannung zu einer unteren Grenzspannung $U_{Batt,grenz}$ verwendet werden, bei der der Energiespeicher die für den Betrieb des betrachteten Verbrauchers (z.B. elektrische Lenkung, Bremse, Starter, ...) erforderliche Leistung gerade noch erbringt:

$$SOH_{abs} = min(U_{Batt,präd}) - U_{Batt,grenz}$$

Bezieht man $SOH_{abs}$ auf die Differenz, die man im günstigsten Fall, also bei einer neuen vollgeladenen Batterie u. hohen Temperaturen erhält, bekommt man das relative Maß:

$$SOH_{rel} = (min(U_{Batt,präd}) - U_{Batt,grenz}) / (U_{Batt,präd,max} - U_{Batt,grenz})$$

Berechnung der zukünftigen Leistungsfähigkeit

Die zukünftige Leistungsfähigkeit kann abgeschätzt werden, indem die auf den zukünftigen Zeitpunkt bezüglich Batterietemperatur u. Ladezustand extrapolierten Zustandsgrößen ($U_{00}'$) u. Parameter ($R_i'$, $U_{D0}'$) in die Prädiktionsgleichung eingesetzt werden. Die zu erwartende Temperatur $T_{Batt}'$ kann beispielsweise durch Mittelwertbildung der Batterietemperaturen der letzten 10 bis 14 Tage bestimmt werden. Für worst-case-Betrachtungen werden von diesem Wert noch einmal 10K abgezogen.

Die zu erwartende Ruhespannung $U_{00}'$ nach x Tagen Standzeit des Fahrzeugs wird über die Abnahme des Ladezustands aufgrund der Entladung durch den Ruhestrom $I_{Ruhe}$ ermittelt:

$$U_{00}(25°C)' = U_{00}(25°C) + I_{Ruhe} * x * 24h/Q_0 * (U_{00,max}(25°C) - U_{00,min}(25°C))$$

$$U_{00}' = U_{00}(25°C)' + Tk_{U00} * (T_{Batt}' - 25°C), \quad Tk_{U00} = 1.38e-6V/°C$$

Der Innenwiderstand $R_i'$ wird mit Hilfe des Kennfelds $R_i' = f(R_i, U_{00}', T_{Batt}')$ extrapoliert, während der Durchtrittsparameter $U_{D0}'$ über die Kennlinie $U_{D0}(T_{Batt}')$ berechnet wird.

**Patentansprüche**

1. Verfahren zur Ermittlung des Ladezustands und/oder der Leistungsfähigkeit eines Ladungsspeichers, wobei aus den gemessenen Größen Batteriespannung, Batteriestrom und Batterietemperatur nach einem ersten Verfahren Zustandsgrößen und Parameter bestimmt werden und nach einem zweiten, modellbasierten Verfahren weitere Zustandsgrößen und Parameter bestimmt werden und daraus Korrekturgrößen ermittelt werden und die Zustandsgrößen zur Ladezustandsberechnung verwendet werden und die Zustandsgrößen und die Parameter zur Prädiktion der Leistungsfähigkeit des Ladungsspeichers und zur Bestimmung der vorherbestimmten Batteriespannung verwendet werden, wobei die genannten Größen in den wenigstens zwei unterschiedlichen Verfahren jeweils bei wenigstens zwei unterschiedlichen Betriebspunkten des Ladungsspeichers ermittelt werden, **dadurch gekenn-**

**zeichnet, dass** die beiden Betriebszustände der Ruhezustand des Ladungsspeichers bzw. ein aktiver Zustand des Ladungsspeichers sind.

2. Verfahren zur Ermittlung des Ladezustands und/oder der Leistungsfähigkeit eines Ladungsspeichers nach Anspruch 1, **dadurch gekennzeichnet, dass** aus den Informationen gewichtbare Korrekturgrößen gebildet werden.

3. Verfahren zur Ermittlung des Ladezustands und/oder der Leistungsfähigkeit eines Ladungsspeichers nach Anspruch 1 oder 2, **dadurch gekennzeichnet, dass** die Abschätzungen hinsichtlich eines aktuellen und/oder künftigen Ladezustands und/oder einer aktuellen und/oder einer künftigen Leistungsfähigkeit des Ladungsspeichers erfolgen.

4. Verfahren zur Ermittlung des Ladezustands und/oder der Leistungsfähigkeit eines Ladungsspeichers nach Anspruch 2, **dadurch gekennzeichnet, dass** die Abschätzung hinsichtlich des künftigen Ladezustandes und/oder der künftigen Leistungsfähigkeit des Ladungsspeichers mittels eines Prädiktors erfolgen.

5. Verfahren zur Ermittlung des Ladezustands und/oder der Leistungsfähigkeit eines Ladungsspeichers nach einem der vorhergehenden Ansprüche, **dadurch gekennzeichnet, dass** eine Zustands- und Parameterschätzung erfolgt.

6. Verfahren zur Ermittlung des Ladezustands und/oder der Leistungsfähigkeit eines Ladungsspeichers nach Anspruch 5, **dadurch gekennzeichnet, dass** zur Zustands- und Parameterschätzung ein Ruhespannungsverfahren und ein modellbasiertes Schätzverfahren durchgeführt werden.

7. Verfahren zur Ermittlung des Ladezustands und/oder der Leistungsfähigkeit eines Ladungsspeichers nach einem der vorhergehenden Ansprüche, **dadurch gekennzeichnet, dass** Rechenmodelle gebildet werden, die unter Berücksichtigung vorgebbarer Größen in einem Prozessor abarbeitbar sind.

8. Vorrichtung zur Durchführung wenigstens eines Verfahrens zur Ermittlung des Ladezustands und/oder der Leistungsfähigkeit eines Ladungsspeichers nach einem der vorhergehenden Ansprüche, **dadurch gekennzeichnet, dass** sie wenigstens einen Prozessor, der insbesondere Bestandteil eines Steuergerätes ist, umfasst, dem die benötigten Informationen zugeführt werden.

9. Vorrichtung zur Ermittlung des Ladezustands und/oder der Leistungsfähigkeit eines Ladungsspeichers nach Anspruch 10, **dadurch gekennzeichnet, dass** Mittel zur Zustands- und Parameterschätzung, Mittel zur Ladezustandsberechnung und Mittel zur Prädiktion der Leistungsfähigkeit vorhanden sind und miteinander in Verbindung stehen.

**Claims**

1. Method for determining the charge state and/or the efficiency of a charge store, wherein state variables and parameters are established from the measured variables of battery voltage, battery current and battery temperature according to a first method, and further state variables and parameters are established according to a second, model-based method, and correction variables are determined from these, and the state variables are used for charge state calculation and the state variables and the parameters are used to predict the efficiency of the charge store and to establish the previously established battery voltage, wherein the said variables in the at least two different methods are each determined at at least two different operating points of the charge store, **characterized in that** the two operating states are the inoperative state of the charge store and an active state of the charge store.

2. Method for determining the charge state and/or the efficiency of a charge store according to Claim 1, **characterized in that** correction variables which can be weighted are formed from the information.

3. Method for determining the charge state and/or the efficiency of a charge store according to Claim 1 or 2, **characterized in that** the estimations are carried out in respect of a current and/or future charge state and/or a current and/or a future efficiency of the charge store.

4. Method for determining the charge state and/or the efficiency of a charge store according to Claim 2, **characterized in that** the estimations in respect of the future charge state and/or the future efficiency of the charge store are carried out by means of a predictor.

5. Method for determining the charge state and/or the efficiency of a charge store according to one of the preceding claims, **characterized in that** a state and parameter estimation is carried out.

6. Method for determining the charge state and/or the efficiency of a charge store according to Claim 5, **characterized in that** a quiescent voltage method and a model-based estimation method are carried out for the purpose of state and parameter estimation.

7. Method for determining the charge state and/or the efficiency of a charge store according to one of the preceding claims, **characterized in that** computer models are formed and can be processed in a processor, taking into account predefinable variables.

8. Apparatus for carrying out at least one method for determining the charge state and/or the efficiency of a charge store according to one of the preceding claims, **characterized in that** it comprises at least one processor which is, in particular, a constituent part of a controller and to which the required information is supplied.

9. Apparatus for determining the charge state and/or the efficiency of a charge store according to Claim 10, **characterized in that** means for state and parameter estimation, means for charge state calculation and means for predicting the efficiency are present and are connected to one another.

**Revendications**

1. Procédé pour déterminer l'état de charge et/ou la puissance disponible d'un accumulateur de charge, des grandeurs d'état et des paramètres étant déterminés selon un premier procédé à partir des grandeurs mesurées : tension de batterie, courant de batterie et température de batterie ; et des grandeurs d'état ainsi que des paramètres supplémentaires étant déterminés selon un deuxième procédé basé sur un modèle et des grandeurs de correction étant définies à partir de ceux-ci et les grandeurs d'état étant utilisées pour calculer l'état de charge et les grandeurs d'état ainsi que les paramètres étant utilisés pour prévoir la puissance disponible de l'accumulateur de charge et pour déterminer la tension de batterie prédéterminée, lesdites grandeurs étant déterminées dans les au moins deux procédés différents à chaque fois à au moins deux points de fonctionnement différents de l'accumulateur de charge, **caractérisé en ce que** les deux états opérationnels sont l'état de repos de l'accumulateur de charge ou un état actif de l'accumulateur de charge.

2. Procédé pour déterminer l'état de charge et/ou la puissance disponible d'un accumulateur de charge selon la revendication 1, **caractérisé en ce que** des grandeurs de correction pondérables sont formées à partir des informations.

3. Procédé pour déterminer l'état de charge et/ou la puissance disponible d'un accumulateur de charge selon la revendication 1 ou 2, **caractérisé en ce que** les estimations sont effectuées en vue d'un état de charge actuel et/ou futur et/ou d'une puissance disponible actuelle et/ou future de l'accumulateur de charge.

4. Procédé pour déterminer l'état de charge et/ou la puissance disponible d'un accumulateur de charge selon la revendication 2, **caractérisé en ce que** les estimations en vue de l'état de charge futur et/ou de la puissance disponible future de l'accumulateur de charge sont effectuées au moyen d'un dispositif de prédiction.

5. Procédé pour déterminer l'état de charge et/ou la puissance disponible d'un accumulateur de charge selon l'une des revendications précédentes, **caractérisé en ce qu'**une estimation de l'état et des paramètres est effectuée.

6. Procédé pour déterminer l'état de charge et/ou la puissance disponible d'un accumulateur de charge selon la revendication 5, **caractérisé en ce qu'**un procédé de tension de repos et un procédé d'estimation basé sur un modèle sont appliqués pour l'estimation de l'état et des paramètres.

7. Procédé pour déterminer l'état de charge et/ou la puissance disponible d'un accumulateur de charge selon l'une des revendications précédentes, **caractérisé en ce que** sont formés des modèles de calcul qui peuvent être traités dans un processeur en tenant compte de grandeurs pouvant être prédéfinies.

8. Dispositif pour mettre en oeuvre au moins un procédé pour déterminer l'état de charge et/ou la puissance disponible d'un accumulateur de charge selon l'une des revendications précédentes, **caractérisé en ce qu'**il comprend au moins un processeur, qui fait notamment partie d'un module de commande, auquel sont acheminées les informations nécessaires.

**9.** Dispositif pour déterminer l'état de charge et/ou la puissance disponible d'un accumulateur de charge selon la revendication 10, **caractérisé en ce qu'**il existe des moyens d'estimation de l'état et des paramètres, des moyens de calcul de l'état de charge et des moyens de prévision de la puissance disponible et qu'ils sont reliés entre eux.

# Fig. 1

# Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE P19847648
- DE P19959019
- DE P10056969
- DE 19960761 C1